# EUROPÄISCHE PATENTANMELDUNG

(11) **EP 1 063 703 A1**
(43) Veröffentlichungstag der Anmeldung: **27.12.2000**
(21) Anmeldenummer: 00111573.2
(22) Anmeldetag: 30.05.2000
(51) Int. Cl.: H01L 27/02

(54) **Schaltungsanordnung zur Verhinderung der Injektion von Minoritätsladungsträgern in das Substrat**

(30) Priorität: 23.06.1999 DE 19928762
(71) Anmelder: Infineon Technologies AG, 81541 München (DE)
(72) Erfinder: Feldtkeller, Martin, 81543 München (DE); Tihanyi, Jenö, Dr., 85551 Kirchheim (DE)
(74) Vertreter: Zedlitz, Peter, Dipl.-Inf.

(57) **Zusammenfassung**

Schaltungsanordnung zur Verhinderung der Injektion von Minoritätsladungsträgern in das Substrat bei integrierten Halbleiterschaltungen, die folgende Merkmale aufweist:
- wenigstens einen Schalter (S1; S3) zum Anschließen zwischen einer Ausgangsklemme (A1; A3) und einem Substratanschluß (SUB) der Halbleiterschaltung;
- eine Ansteuerschaltung (AS) mit wenigstens einer Eingangsklemme (EK1; EK3) zur Zuführung eines von einem Potential an der Ausgangsklemme (A1; A3) abhängigen Eingangssignals (ES1; ES3) und mit wenigstens einer Ausgangsklemme (AK1; AK3) zur Ansteuerung des wenigstens einen Schalters (S1; S3) abhängig von dem Eingangssignal (ES1; ES3).

## Beschreibung

Die vorliegende Erfindung betrifft eine Schaltungsanordnung zur Verhinderung der Injektion von Minoritätsladungsträgern in das Substrat bei integrierten Halbleiterschaltungen.

Die Erfindung ist insbesondere zur Verwendung im Zusammenhang mit sperrschichtisolierten integrierten Schaltungen in Mischtechnologie mit CMOS-Transistoren, DMOS-Transistoren und Bipolartransistoren geeignet. Zur Isolation der einzelnen Bauteile gegen das Substrat sind dabei pn-Übergänge gebildet, die zur Gewährleistung der Isolation in Sperrichtung gepolt sein müssen. Hierzu ist es erforderlich, daß das Substrat bei Verwendung eines P-Substrats das niedrigste Potential und bei Verwendung eines N-Substrats das höchste Potential in der Schaltung aufweist. Ein P-Substrat wird dazu üblicherweise auf Massepotential gelegt.

Bei der Ansteuerung externer Bauteile oder Schaltungen mittels derartiger Halbleiterschaltungen, kann es vorkommen, daß Ausgänge auf ein niedrigeres Potential als Substratpotential (bei einem P-Substrat) bzw. daß Ausgänge auf ein höheres Potential als Substratpotential (bei einem N-Substrat) gezogen werden. Dabei kann es zur Injektion von Minoritätsladungsträgern in das Substrat kommen. Die Minoritätsladungsträger breiten sich in dem Substrat aus und beeinträchtigen die Funktionsfähigkeit der Schaltung.

Eine mögliche Abhilfe dieses Problems wird durch die aus der DE 35 07 181 C2 bekannte Schaltungsanordnung geschaffen. Dabei wird ein invers betriebener Bipolartransistor genutzt, das Substratpotential lokal um einen in Flußrichtung gepolten pn-Übergang um einige Millivolt abzusenken, um den pn-Übergang zu sperren. Die Schaltung ist dabei in der Lage, das Substratpotential lediglich um einige 100 mV abzusenken.

Zur Verhinderung der Injektion von Minoritätsladungsträgern in das Substrat von integrierten Halbleiterschaltungen weist die erfindungsgemäße Schaltungsanordnung wenigstens einen Schalter zum Anschließen zwischen einer Ausgangsklemme und einem Substratanschluß der Halbleiterschaltung auf. Über die Ausgangsklemme der Halbleiterschaltung ist beispielsweise eine externe Schaltung ansteuerbar. Die Schaltungsanordnung weist weiterhin eine Ansteuerschaltung auf mit einer Eingangsklemme zur Zuführung eines von einem Potential an der Ausgangsklemme der Halbleiterschaltung abhängigen Eingangssignals und mit einer Ausgangsklemme zur Ansteuerung des Schalter abhängig von dem Eingangssignal.

Sinkt das Potential an der Ausgangsklemme bei Schaltungen mit einem P-Substrat unter den Wert des Substratpotentials bzw. steigt bei Schaltungen mit einem N-Substrat das Potential an der Ausgangsklemme über den Wert des Substratpotentials schließt der Schalter angesteuert durch die Ansteuerschaltung, wodurch das Substratpotential den Wert des Potentials an der Ausgangsklemme annimmt. Dadurch ist gewährleistet, daß die pn-Übergänge zum Substrat auch bei großen Spannungsdifferenzen zwischen Substrat und Ausgangsklemme stets sperren.

Die Schaltungsanordnung weist vorzugsweise einen zweiten Schalter auf, der zwischen einem Bezugspotential und dem Substratanschluß anschließbar und mittels einer zweiten Ausgangsklemme der Ansteuerschaltung ansteuerbar ist. Einer Eingangsklemme der Ansteuerschaltung ist dabei vorzugsweise ein von dem Bezugspotential abhängiges zweites Eingangssignal zuführbar.

Die Ausgangsklemmen sind vorzugsweise direkt an die Eingangsklemmen der Auswerteschaltung angeschlossen. Die Eingangssignale entsprechen dann den Potentialen an den jeweiligen Ausgangsklemmen.

Die Auswerteschaltung weist gemäß einer Ausführungsform einen Vergleicher auf, der die Potentiale an den Ausgangsklemmen bzw. die davon abhängigen Eingangssignale vergleicht, wobei eine Ansteuerung der Schalter abhängig von dem Vergleichsergebnis erfolgt. Ist bei einem P-Substrat das Potential an der wenigstens einen Ausgangsklemme geringer als das Bezugspotential bzw. ist bei einem N-Substrat das Potential an der wenigstens einen Ausgangsklemme größer als das Bezugspotential schließt der an die Ausgangsklemme angeschlossene Schalter und legt das Substrat auf das gegenüber dem Bezugspotential niedrigere bzw. höhere Potential. Ansonsten schließt der an das Bezugspotential angeschlossene Schalter, wodurch das Substrat an das Bezugspotential -üblicherweise Massepotentialangeschlossen ist.

Parallel zu dem das Bezugspotential und den Substratanschluß verbindenden Schalter ist gemäß einer Ausführungsfrom der Erfindung ein Widerstand geschaltet. An das Substrat wird über diesen Widerstand beim Einschalten, wenn noch keiner der Schalter geschlossen ist, ein definierter Potentialwert angelegt.

Die Schaltungsanordnung weist gemäß einer weiteren Ausführungsform vorzugsweise weitere Schalter auf, die jeweils zwischen Ausgangsanschlüssen der Halbleiterschaltung und deren Substratanschluß anschließbar sind. Die Schalter sind über weitere Ausgangsklemmen der Ansteuerschaltung ansteuerbar. Die Ansteuerschaltung weist weitere Eingangsklemmen auf, denen weitere von den Potentialen an den Ausgangsklemmen abhängige Eingangssignale zuführbar sind, wobei eine Ansteuerung der Schalter abhängig von einem Vergleich der Eingangssignale erfolgt. Angesteuert durch die Ansteuerschaltung schließt dabei der Schalter, der bei einem P-Substrat an die Ausgangsklemme mit dem niedrigsten Potential und bei einem N-Substrat an die Ausgangsklemme mit dem höchsten Potential angeschlossen ist.

Zum Vergleich der Eingangssignale weist die Ansteuerschaltung eine Vergleicherschaltung mit einer der Anzahl der Eingangsklemmen entsprechenden Anzahl Transistoren auf, wobei jeweils ein Transistor mit einem Laststreckenanschluß an eine Eingangsklemme angeschlossen ist und wobei die Steueranschlüsse der Transistoren an eine gemeinsame Stromquelle angeschlossen sind. An dem anderen Laststreckenanschluß jedes Transistors ist vorzugsweise eine Stromquelle als Last angeschlossen. An jedem dieser Laststreckenanschlüsse ist ein Ausgangssignal zur Ansteuerung der Schalter abgreifbar. Bei dieser Anordnung leitet nur der Transistor, dessen einer Laststreckenanschluß über die Eingangsklemme, je nach Ausführungsform des Transistors, auf dem niedrigsten Potential bzw. dem höchsten Potential liegt.

Die Erfindung wird nachfolgend in Ausführungsbeispielen anhand von Figuren näher erläutert. Es zeigen:
- Figur 1:: Querschnitt durch einen Halbleiterkörper mit einer Ausgangsstufe einer integrierten Halbleiterschaltung (Fig. 1a); Ersatzschaltbild der in Fig. 1a ausschnittsweise dargestellten Schaltung (Fig. 1b);
- Figur 2:: Blockschaltbild einer erfindungsgemäßen Schaltungsanordnung zur Verhinderung der Injektion von Ladungsträgern in das Substrat;
- Figur 3:: Ausführungsbeispiel einer Ansteuerschaltung der erfindungsgemäßen Schaltungsanordnung.

In den Figuren bezeichnen, sofern nicht anders angegeben, gleiche Bezugszeichen gleiche Bauteile und Funktionseinheiten mit gleicher Bedeutung.

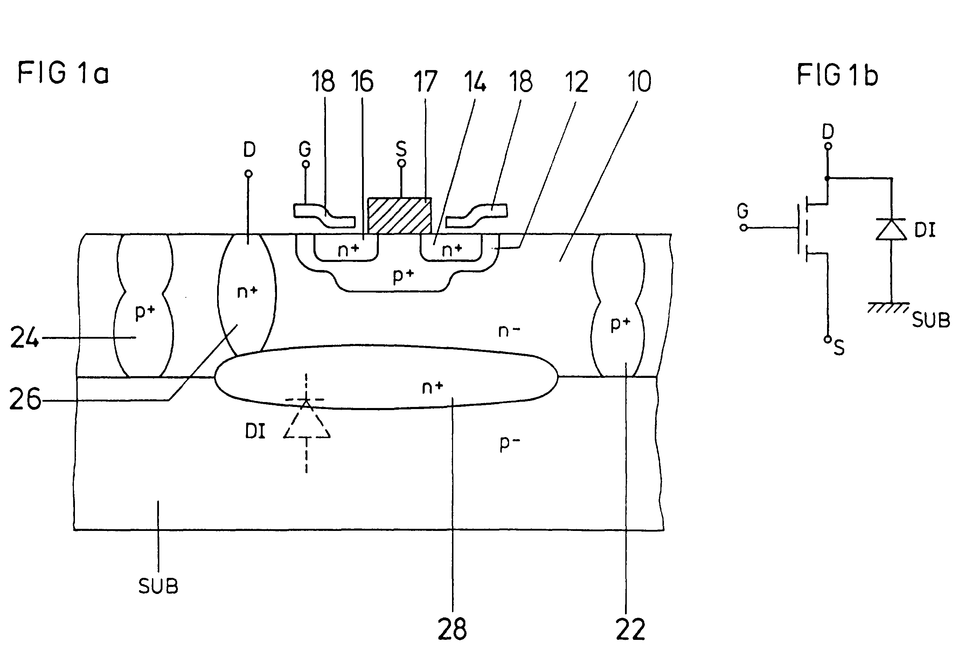

Zur Veranschaulichung eines möglichen Verwendungszwecks der erfindungsgemäßen Schaltungsanordnung ist in Figur 1 beispielhaft eine Ausgangsstufe einer integrierten Halbleiterschaltung dargestellt. Figur 1a zeigt ausschnittsweise einen Querschnitt durch einen Halbleiterkörper, in dem die Schaltung integriert ist, Figur 1b zeigt das elektrische Schaltbild des in Figur 1a dargestellten Ausschnitts des Halbleiterkörpers.

In Figur 1a ist ein Querschnitt durch einen Halbleiterkörper dargestellt, der auf einem P-Substrat SUB basiert und in dem in Mischtechnologie CMOS-Transistoren, DMOS-Transistoren und Bipolartransistoren realisierbar sind. Über dem Substrat SUB ist eine n-dotierte Schicht 10, vorzugsweise eine Epitaxieschicht, aufgebracht. In dem dargestellten Ausschnitt des Halbleiterkörpers ist ein DMOS-Transistor gebildet. Dazu ist in die n-dotierte Schicht 10 eine p-dotierte Wanne 12 eingebracht, in die wiederum zwei n-dotierte Wannen 14, 16 eingebracht sind, die als Source Gebiete dienen und die über ein leitfähiges Material 17 kontaktierbar sind. Eine in dem Ausführungsbeispiel ringförmige Gate-Elektrode 18, G ist oberhalb des Halbleiterkörpers, von diesem durch eine nicht dargestellte Isolationsschicht getrennt, angeordnet. Der Drain-Bereich des MOSFET wird durch einen stark n-dotierten Bereich 28 zwischen Substrat SUB und Schicht 10 und einen stark n-dotierten Bereich 26, der sich von dem Bereich 28 nach oben erstreckt, gebildet. In Figur 1a sind noch zwei p-dotierte Bereiche 22, 24 dargestellt, die zur Isolation des MOSFET gegen benachbarte Bauelemente dienen.

Probleme mit injizierten Minoritätsladungsträgern ergeben sich für das dargestellte Beispiel, wenn an dem Drain-Anschluß D des MOSFET durch eine anzusteuernde Last ein Potential anliegt, welches niedriger als das Potential des Substrats SUB ist. Ein pn-Übergang zwischen dem Drain-Bereich 28, 26 und dem Substrat ist dann in Flußrichtung gepolt und leitet Ladungsträger in das Substrat SUB, die sich dort ausbreiten und die Schaltungsfunktion stören. Der pn-Übergang ist in Figur 1b als Diode DI zwischen dem Drain-Anschluß D und dem Substrat SUB dargestellt. Das Schaltsymbol der Diode DI ist in Figur 1a zur Veranschaulichung gestrichelt eingezeichnet.

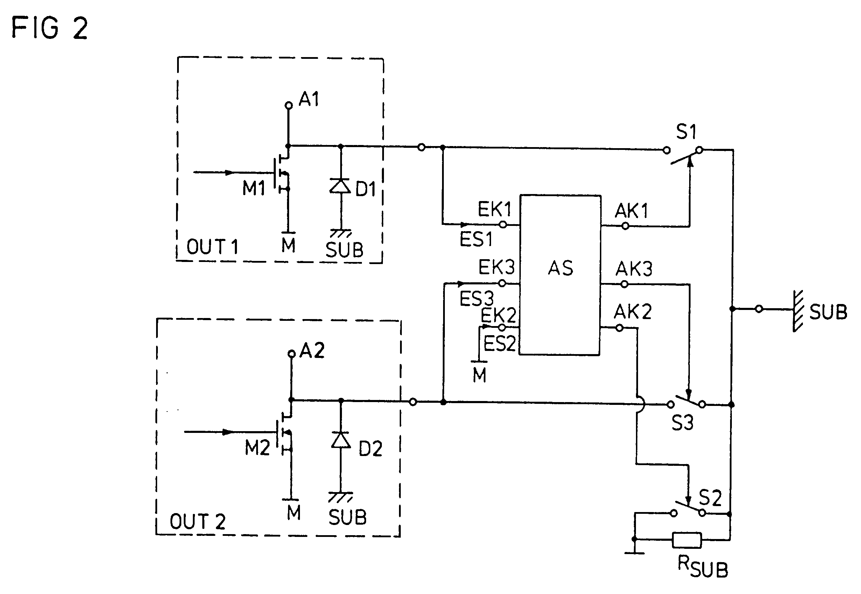

Figur 2 zeigt ein Ausführungsbeispiel einer erfindungsgemäßen Schaltungsanordnung zur Verhinderung der Injektion von Minoritätsladungsträgern in das Substrat SUB bei integrierten Halbleiterschaltungen. Die Schaltungsanordnung ist zwischen wenigstens einer Ausgangsklemme A1; A2 und dem Substrat der Halbleiterschaltungsanordnung anschließbar. Zur Veranschaulichung sind in Figur 2 beispielhaft zwei Ausgangsstufen OUT1, OUT2 einer integrierten Halbleiterschaltung, die von der in Figur 1 beschriebenen Art sind, dargestellt. Dabei dient ein MOSFET M1, M2 jeder Ausgangsstufe OUT1, OUT2 als Low-Side-Schalter zum Anschalten einer an eine Ausgangsklemme A1, A2 anschließbaren Last an ein Bezugspotential M. D1, D2 bezeichnet die unvermeidlich in dem Halbleiterkörper gebildeten Dioden zwischen den Drain-Anschlüssen der MOSFET M1, M2 und dem Substrat SUB. Der Substratanschluß SUB der Halbleiterschaltung kann beispielsweise durch einen Kontaktring um alle Low-Side-Schalter M1, M2 in dem Halbleiterkörper gebildet sein, wobei Substratbereiche, die von Low-Side-Schaltern entfernt sind, beispielsweise dauerhaft an Bezugspotential gelegt werden können. Es besteht auch die Möglichkeit, alle Substratkontakte in dem Halbleiterschalter zu einem gemeinsamen Substratanschluß zusammenzuschließen. Die zweite Variante eignet sich besser für integrierte Schaltungen, bei denen der Chip auf der Rückseite mit Masse verbunden ist. Die erste Variante eignet sich für Chips, deren Rückseite keine weitere elektrische Verbindung hat.

Die erfindungsgemäße Schaltungsanordnung weist einen ersten Schalter S1 auf, der zwischen einer Ausgangsklemme A1 und einem Substratanschluß SUB der Halbleiterschaltung anschließbar ist. Eine Ansteuerschaltung AS dient zur Ansteuerung des Schalters S1 über eine erste Ausgangsklemme AK1. Die Ansteuerung erfolgt abhängig von einem einer Eingangsklemme EK1 zuführbaren Eingangssignal ES1, welches von einem Potential an der Ausgangsklemme A1 abhängig ist. Die Eingangsklemme EK1 ist in dem Ausführungsbeispiel an eine Klemme des Schalters S1 und dadurch direkt an die Ausgangsklemme A1 anschließbar.

Ein zweiter Schalter S2 ist zwischen dem Substratanschluß SUB und einem Bezugspotential M anschließbar. Zu seiner Ansteuerung ist der zweite Schalters S2 an eine zweite Ausgangsklemme AK2 der Ansteuerschaltung angeschlossen. Einer zweiten Eingangsklemme EK2 ist ein von dem Bezugspotential M abhängiges zweites Eingangssignal ES2, in dem Ausführungsbeispiel das Bezugspotential M selbst als Eingangssignal ES2 direkt, zugeführt.

Ein weiterer Schalter S3 ist zwischen einer weiteren Ausgangsklemme A2 und dem Substratanschluß SUB anschließbar. Zu seiner Ansteuerung ist der weitere Schalter S3 an eine weitere Ausgangsklemme AK3 der Ansteuerschaltung angeschlossen, wobei eine weitere Eingangsklemme EK3 der Ansteuerschaltung an eine Klemme des Schalters S3 und dadurch an die Ausgangsklemme A2 zur Zuführung eines von dem Potential an der Ausgangsklemme A2 abhängigen Eingangssignals ES3 angeschlossen ist. Es können beliebig viele weitere Schalter zwischen weiteren Ausgangsklemmen der Halbleiterschaltung und dem Substratanschluß SUB vorgesehen werden, die über weitere Ausgangsklemmen der Ansteuerschaltung AS ansteuerbar sind.

Die Ansteuerschaltung vergleicht die Eingangssignale ES1, ES2, ES3 bzw. die Potentiale an den Ausgangsklemmen A1, A2 und das Bezugspotential M und schließt den Schalter S1; S2; S3, der in dem Ausführungsbeispiel an das niedrigste Potential angeschlossen ist.

Als Bezugspotential M ist üblicherweise Massepotential gewählt, welches im Normalbetrieb niedriger sein dürfte als die Potentiale an den Ausgangsklemmen A1, A2. In diesem Fall ist der zweite Schalter S2 geschlossen und legt das Substrat SUB auf Bezugspotential M. Sinkt das Potential an einer der Ausgangsklemmen A1; A2 bedingt durch eine daran angeschlossene externe Schaltung unter das Bezugspotential M ab, wird der Schalter S2 geöffnet und der an diesen Ausgang A1; A2 angeschlossene Schalter S1; S3 geschlossen und legt damit das Substrat SUB auf dieses niedrigere Potential. Dadurch wird verhindert, daß die zwischen dem Ausgang A1; A2 und dem Substrat SUB gebildete Diode D1; D2 leitet und Minoritätsladungsträger in das Substrat SUB injiziert werden .

Ein zwischen den Substratanschluß SUB und das Bezugspotential M geschalteter Widerstand R_{SUB} bewirkt, daß das Substrat SUB beim Einschalten, wenn noch keiner der Schalter S1, S2, S3 geschlossen ist, einen definierten Wert annimmt. Der Widerstand beträgt etwa 50-500 Ohm. Der Widerstand ist so gewählt, daß die Einschaltwiderstände der Schalter S1, S2, S2 höchstens 1/5 des Widerstandswertes des Widerstands R_{SUB} betragen.

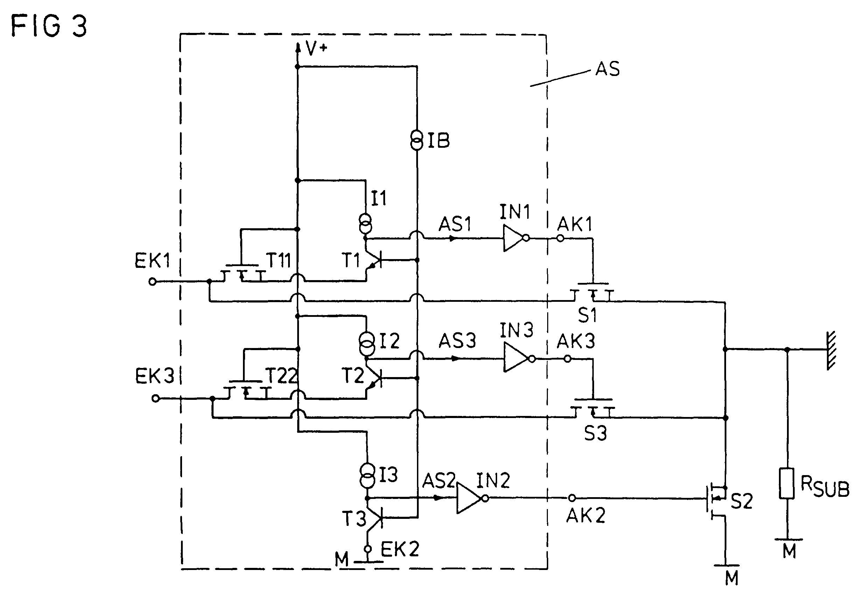

Figur 3 zeigt ein Ausführungsbeispiel einer Ansteuerschaltung AS zur Ansteuerung der Schalter S1, S2, S3. Die Ansteuerschaltung AS weist eine der Anzahl der Eingangsklemmen EK1, EK2, EK3 entsprechende Anzahl Transistoren T1, T2, T3, -in dem Beispiel npn-Bipolartransistoren- auf. Der Emitteranschluß jeweils eines der Transistoren T1, T2, T3 ist dabei an eine der Eingangsklemmen EK1; EK2; EK3 angeschlossen. Als Schutz vor Überspannung ist zwischen die erste Eingangsklemme EK1 und den Transistor T1 und die weitere Eingangsklemme EK3 und den Transistor T2 jeweils ein MOSFET T11, T12 geschaltet, dessen Gate-Elektrode an ein Versorgungspotential V+ angeschlossen ist. Die Verwendung der MOSFET T11, T12 ist optional. Es kann darauf verzichtet werden, wenn sichergestellt ist, daß an den Eingangsklemmen EK1, EK3 keine die Transistoren T1, T2 zerstörende Spannung anliegen kann.

Die Basisanschlüsse der Transistoren T1, T2, T3 sind an eine gemeinsame Stromquelle IB angeschlossen. Als Last ist zwischen den Kollektoranschluß K jedes der Transistoren T1, T2, T3 und das Versorgungspotential V+ jeweils eine Stromquelle I1, I2, I3 geschaltet.

Ansteuersignale AS1, AS2, AS3 zur Ansteuerung der Schalter sind an den Kollektoranschlüssen der Transistoren T1, T2, T3 abgreifbar, wobei in dem Ausführungsbeispiel die Ansteuersignale AS1, AS2, AS3 invertiert durch Invertierer IN1, IN2, IN3 an den Ausgangsklemmen AK1, AK2, AK3 zur Ansteuerung der Schalter S1, S2, S3 zur Verfügung stehen. Die Schalter sind in dem Beispiel als n-Kanal-MOSFET ausgebildet, deren Gate-Anschlüsse an die Ausgangsklemmen AK1, AK2, AK3 angeschlossen sind.

Die dargestellte Ansteuerschaltung funktioniert wie im folgenden beschrieben.

Von den an die verschiedenen Eingangsklemmen EK1, EK2, EK3 angeschlossenen Bipolartransistoren T1, T2, T3 leitet nur derjenige, dessen Emitterelektrode auf dem niedrigsten Potential liegt. Dieser Transistor T1; T2; T3 übernimmt annaherungsweise den gesamten Strom der Stromquelle IB und wird bis zur Sättigung eingeschaltet, die anderen Transistoren T1; T2; T3 sperren. Als Bezugsgröße dient das Bezugspotential M. Die Transistoren T1 und T2 können nur leiten, wenn das Potential an den Eingangsklemmen EK1, EK3 niedriger als Bezugspotential M ist, ansonsten leitet der Transistor T2. Das Potential am Kollektoranschluß des leitenden Transistors T1; T2; T3 sinkt auf einen niedrigen Wert ab, während die Potentiale der Kollektoranschlüsse der nicht leitenden Transistoren T1; T2; T3 annäherungsweise auf dem Wert des Versorgungspotentials V+ bleiben. Der dem Kollektoranschluß nachgeschaltete Inverter IN1; IN2; IN3 erzeugt aus dem niedrigen Pegel an der Kollektorelektrode des leitenden Transistors einen hohen Pegel, der ausreicht, den angeschlossenen Schalter S1; S2; S3 zu schließen. Die den Kollektoranschlüssen der nicht leitenden Transistoren T1; T2; T3 nachgeschalteten Inverter IN1; IN2; IN3 erzeugen aus den hohen Pegeln niedrige Pegel, die nicht ausreichen, die nachgeschalteten Schalter S1; S2; S3 zu schließen. Damit leitet nur der Schalter S1; S2; S3, der an die Eingangsklemme EK1; EK2; EK3 angeschlossen ist, an der das niedrigste Potential anliegt, und legt dadurch das Substrat SUB auf diesen Potentialwert.

Liegen zwei oder mehr der Eingangsklemmen EK1; EK2; EK3 auf annäherungsweise gleichen niedrigen Potentialen, die sich maximal um einige Millivolt unterscheiden, können die daran angeschlossenen Bipolartransistoren T1; T2; T3 und damit die dadurch angesteuerten Schalter S1; S2; S3 gleichzeitig leiten. Dies ist unkritisch, da die an den geschlossenen Schaltern S1; S2; S3 anliegenden Potentiale nahezu gleich sind so daß nur geringe Ausgleichsströme fließen.

Ist die erfindungsgemäße Schaltungsanordnung derart ausgestaltet, daß sie nur an eine Ausgangsklemme der Halbleiterschaltung anschließbar ist, sind für die Ansteuerschaltung AS lediglich zwei Bipolartransistoren, einer zum Anschluß an die mit der Ausgangsklemme verbundene Eingangsklemme und einer zum Anschluß an Bezugspotential vorzusehen. Dementsprechend sind nur zwei Schalter vorzusehen, einer zum Anschluß des Substrats an die Ausgangsklemme und einer zum Anschluß des Substrats an Bezugspotential. Da in diesem Fall stets einer der beiden Schalter leiten muß, genügt es in der Ansteuerschaltung ein Ansteuersignal am Kollektoranschluß lediglich eines der beiden Bipolartransistoren, in der in Figur 3 beschriebenen Weise, abzugreifen, um einen der Schalter anzusteuern. Dem anderen Schalter ist ein inverses Ansteuersignal zuzuführen, welches vor dem Inverter abgreifbar ist. Auf diese Weise läßt sich bei dieser Ausführungsform ein Inverter einsparen.

Die erfindungsgemäße Schaltungsanordnung wurde in den Ausführungsbeispielen ohne Beschränkung der Allgemeinheit für eine auf einem Substrat basierende Halbleiterschaltung beschrieben. Sie ist selbstverständlich auch für Halbleiterschaltungen verwendbar, die auf einem N-Substrat basieren. Die Ansteuerschaltung ist dabei so ausgestaltet, daß nur der Schalter leitet, der an die Eingangsklemme mit dem höchsten Potential angeschlossen ist.

## Patentansprüche

1. Schaltungsanordnung zur Verhinderung der Injektion von Minoritätsladungsträgern in das Substrat bei integrierten Halbleiterschaltungen,
**gekennzeichnet** durch folgende Merkmale:
- wenigstens einen Schalter (S1; S3) zum Anschließen zwischen einer Ausgangsklemme (A1; A3) und einem Substratanschluß (SUB) der Halbleiterschaltung;
- eine Ansteuerschaltung (AS) mit wenigstens einer Eingangsklemme (EK1; EK3) zur Zuführung eines von einem Potential an der Ausgangsklemme (A1; A3) abhängigen Eingangssignals (ES1; ES3) und mit wenigstens einer Ausgangsklemme (AK1; AK3) zur Ansteuerung des wenigstens einen Schalters (S1; S3) abhängig von dem Eingangssignal (ES1; ES3).

2. Schaltungsanordnung nach Anspruch 1,
**dadurch gekennzeichnet**, daß
sie einen zweiten Schalter (S2) aufweist zum Anschließen zwischen einem Bezugspotential (M) und dem Substratanschluß (SUB), der über eine zweite Ausgangsklemme (AK2) der Ansteuerschaltung (AS) ansteuerbar ist.

3. Schaltungsanordnung nach Anspruch 2,
**dadurch gekennzeichnet**, daß
die Ansteuerschaltung (AS) eine zweite Eingangsklemme (EK2) zur Zuführung eines von dem Bezugspotential (M) abhängigen zweiten Eingangssignals (ES2) aufweist.

4. Schaltungsanordnung nach einem der vorangehenden Ansprüche,
**dadurch gekennzeichnet**, daß
sie weitere Schalter (S3) zum Anschließen zwischen weiteren Ausgangsklemmen (A3) der Halbleiterschaltung und deren Substratanschluß (SUB) aufweist, wobei jeder weitere Schalter (S3) über eine Ausgangsklemme (AK3) der Ansteuerschaltung (AS) ansteuerbar ist.

5. Schaltungsanordnung nach Anspruch 4,
**dadurch gekennzeichnet**, daß
die Ansteuerschaltung (AS) weitere Eingangsklemmen (EK3) zur Zuführung weiterer Eingangssignals (ES3) aufweist, die von Potentialen an den weiteren Ausgangsklemmen (A3) abhängig sind.

6. Schaltungsanordnung nach einem der vorangehenden Ansprüchen,
**dadurch gekennzeichnet**, daß
die Ausgangsklemmen (A1, A2, A3) der Halbleiterschaltung an die Eingangsklemmen (EK1, EK2, EK3) der Ansteuerschaltung (AS) anschließbar sind.

7. Schaltungsanordnung nach einem der vorangehenden Ansprüchen,
**dadurch gekennzeichnet**, daß
ein Widerstand (R_{SUB}) zwischen den Substratanschluß (SUB) und das Bezugspotential (M) geschaltet ist.

8. Schaltungsanordnung nach einem der vorangehenden Ansprüche,
**dadurch gekennzeichnet**, daß
die Ansteuerschaltung eine Vergleicheranordnung zum Vergleich der Eingangssignale (ES1, ES2, ES3) und zur Ansteuerung der Schalter (S1, S2, S3) abhängig von dem Vergleichsergebnis aufweist.

9. Schaltungsanordnung nach Anspruch 8,
**dadurch gekennzeichnet**, daß
der Schalter (S1; S2; S3) ansteuerbar ist, der an die Ausgangsklemme (AK1; AK2; AK3) mit niedrigstem oder höchstem Potential angeschlossen ist.

10. Schaltungsanordnung nach einem der vorangehenden Ansprüche,
**dadurch gekennzeichnet**, daß
die Ansteuerschaltung (AS) eine der Anzahl der Eingänge (EK1, EK2, EK3) entsprechende Anzahl Transistoren (T1, T2, T3) aufweist, wobei an jede Eingangsklemme (EK1, EK2, EK3) jeweils ein erster Laststreckenanschluß eines der Transistoren (T1, T2, T3) angeschlossen ist, wobei Steueranschlüsse der Transistoren an eine gemeinsame Stromquelle (IB) angeschlossen sind und wobei an zweiten Laststreckenanschlüssen der Transistoren (T1, T2, T3) Ansteuersignale (AS1, AS2, AS3) für die Schalter abgreifbar sind.

11. Schaltungsanordnung nach Anspruch 10,
**dadurch gekennzeichnet**, daß
jeweils eine Stromquelle (I1; I2; I3) an den zweiten Laststreckenanschluß der Transistoren (T1, T2, T3) angeschlossen ist.

12. Schaltungsanordnung nach einem der vorangehenden Ansprüche,
**dadurch gekennzeichnet**, daß
den zweiten Laststreckenanschlüssen (K) der Transistoren (T1, T2, T3) jeweils ein Inverter (IN1, IN2, IN3) zur Bereitstellung jeweils eines Ansteuersignals nachgeschaltet ist.
